(19) Europäisches Patentamt
European Patent Office
Office européen des brevets

(11) Publication number: 0 178 200 A1

# (12) EUROPEAN PATENT APPLICATION

(21) Application number: 85401718.3

(22) Date of filing: 05.09.85

(51) Int. Cl.[4]: H 01 L 21/285, C 23 C 16/30

(30) Priority: 10.09.84 US 649032

(43) Date of publication of application: 16.04.86 Bulletin 86/16

(84) Designated Contracting States: DE FR GB IT NL

(71) Applicant: FAIRCHILD CAMERA & INSTRUMENT CORPORATION, 464 Ellis Street, Mountain View California 94042 (US)

(72) Inventor: Lehrer, William I., 1161 Seena Avenue, Los Altos California 94022 (US)

(74) Representative: Chareyron, Lucien et al, Schlumberger Limited Service Brevets c/o Giers 12, place des Etats Unis B.P. 121, F-92124 Montrouge Cédex (FR)

## (54) Method of control for chemical vapor deposition.

(57) Chemical vapor deposition of multiple element materials is controlled through the addition of a control gas to the reaction chamber. In one embodiment in the chemical vapor deposition of the compound $TaSi_2$, a less desirable compound may be formed, viz, $Ta_5Si_3$. By adding HCl as a control gas, those reaction which result in the least HCl as a reaction product are favored. In this case, the reaction which results in $TaSi_2$ is favored, resulting in the deposition of the desirable $TaSi_2$. The method is also applicable to the chemical vapor deposition of mixtures such as p or n type doped polysilicon. Other embodiments are disclosed.

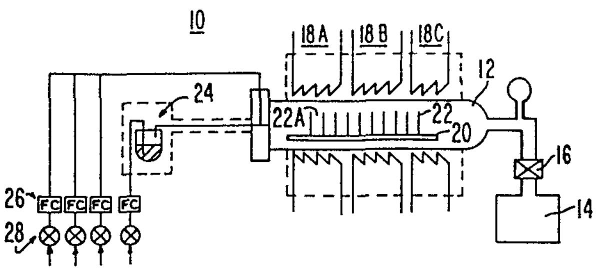


EP 0 178 200 A1

0178200

50.4321

# METHOD OF CONTROL FOR CHEMICAL VAPOR DEPOSITION

By

William I. Lehrer

## Background Of The Invention

The present invention relates to chemical vapor deposition, and more particularly, to a method of controlling such a deposition involving multiple element materials.

Chemical vapor deposition is a well known technique which involves the vaporization and chemical reactions of materials, followed by their deposition on a substrate. Although this technique offers several advantages which make it desirable for use in semiconductor processing applications, the technique exhibits several undesirable characteristics.

One such undesirable characteristic is that the technique is difficult to control in applications involving deposition of multiple element materials. For example, the chemical vapor deposition of mixtures, such as arsenic doped polysilicon, or compounds, such as tantalum silicide, are difficult to control because the source vapors of the constituents do not decompose at the same rate. In this connection, in the chemical vapor deposition of doped polysilicon, the different decomposition rates of the

constituents, viz, polysilicon and the dopant, e.g., arsenic, result in an undesirably large variation in dopant concentration in the deposition. This problem is exacerbated by the common process of establishing a multizone furnace wherein the temperature across the reaction chamber is chosen to optimize the polysilicon deposition, e.g., 550°C; 600°C; 650°C. Referring to the chemical vapor deposition of tantalum silicide, the constituents typically include: Silane ($SiH_4$); tantalum chloride ($TaCl_5$); and hydrogen ($H_2$) carrier gas. As a result of the different decomposition rates of these constituents, although tantalum silicide in the form of $TaSi_2$ is desired because of its low resistivity, the less desirable form of $Ta_5Si_3$ is often formed. Further information on the chemical vapor deposition of tantalum silicide can be found in U.S. Patent No. 4,359,490, entitled "METHOD FOR LPCVD CO-DEPOSITION OF METAL AND SILICON TO FORM METAL SILICIDE" issued to Fairchild Camera & Instrument Corporation on November 16, 1982, hereby incorporated by reference.

The difficulties involved in such multiple element chemical vapor deposition are currently handled to some extent by a fortuitous choice of temperature and/or constituent gases. Where such choices do not exist or provide unacceptable results, post deposition heating cycles may be required to effect a further reaction of the deposited film. However, to date none of these techniques

has provided acceptable control for such multiple element chemical vapor depositions. In addition, current techniques are desirable inasmuch as they generally add complexity and can result in structural film problems during reaction as well as add cost to the conventional chemical vapor deposition technique.

Accordingly, it is a general object of this invention to provide an improved method of chemical vapor deposition.

Another object of this invention is to provide such as method for controlling the chemical vapor deposition of multiple element materials to secure desired reaction products.

Another object of this invention is to provide such as method which can be conveniently applied to the conventional chemical vapor deposition technique.

## Summary of the Invention

It is a general object of the present invention to provide an improved method of chemical vapor deposition.

This and other objects are attained, in accordance with one aspect of the invention by a method of controlling chemical vapor deposition of multiple element materials, comprising the steps of: a) providing a vapor deposition chamber, b) providing source materials in the chamber having different source vapor decomposition rates wherein a plurality of different reactions are possible during deposition, and c) adding a control gas to the chamber during deposition to favor one or more predetermined ones of the different reactions.

particularly pointing out and distinctly claiming that which is regarded as the present invention, the objects and advantages of this invention can be more readily ascertained from the following description of preferred embodiments, when read in conjunction with the accompanying Drawing, in which:

Figure 1 is a partially broken-away schematic representation of a conventional chemical vapor deposition chamber suitable for use in practicing the method of the present invention.

Figure 2A and 2B are representations of Auger analysis wherein Figure 2A shows the spectra without the use of the control gas of the present invention and Figure 2B shows the spectra with the use of the control gas of the present invention.

Detailed Description Of The Invention

Referring initially to Figure 1, an exemplary conventional chemical vapor deposition apparatus suitable for use in practicing the method of the present invention is generally designated 10. The apparatus 10 includes a reaction chamber 12, coupled to a pump 14 through a valve 16. The chamber 12 is coupled to a three zone furnace 18A, 18B, 18C, for establishing a desired temperature gradient across the chamber 12. The chamber 12 includes a support 20 which receives the substrates, e.g., wafers 22, which will receive the chemical vapor deposition. The apparatus 10 includes a heated zone 24 and flow control values 26, 28.

As discussed previously, in the chemical vapor deposition of tantalum silicide, the typical result is the formation of the less desirable compound of $Ta_5Si_3$, instead of the desirable compound of $TaSi_2$. More particularly, in this chemical vapor deposition, there are only two probable chemical reactions, viz:

(1) $6SiH_4 + 10TaCl_5 + 13H_2 \dashrightarrow 2Ta_5Si_3 + 50HCl$

(2) $4SiH_4 + 2TaCl_5 \dashrightarrow 2TaSi_2 + 10HCl + 3H_2$

Under the standard reaction conditions of about 600°C tc about 650°C across zones 18A, 18B, 18C, reaction (1) is favored, resulting in the deposition of $Ta_5Si_3$ instead of the desirable compound of $TaSi_2$. However, I have found that, by the addition of HCL gas to the reaction stream in the chamber 12, those reactions which result in the least HCl as a reaction product are favored. Thus, the addition of HCl favors reaction (2), resulting in the deposition of the desirable $TaSi_2$, instead of the less desirable $Ta_5Si_3$.

The above technique can also be used to control the chemical vapor deposition of mixtures, such as arsenic doped polysilicon. In this connection, the doped polysilicon is a mixture, the uniformity of its deposition being dependent upon the rates of the following reactions in the reaction chamber 12, viz:

(3) $SiH_4 \dashrightarrow Si + 2H_2$

(4) $2AsCl_3 + 3H_2 \dashrightarrow 2As + 6HCl$

At a fixed temperature, e.g., 600°C, the rate of reaction (3) can be controlled by the silane ($SiH_4$) to

hydrogen ($H_2$) ratio. The rate of reaction (4) can be controlled by the amount of HCl added to the reaction stream in the chamber. In this connection, although the parameters are dependent upon reactor geometry, I have found that the addition of HCl in the form of 15-40% of the total gas inject volume was effective in producing the desired result. Such a doping level is generally referred to as n-type doping.

Although the method of the present invention has been described with exemplary materials, the method is suitable for deposition of other multiple element materials. For example, in the case of the chemical vapor deposition of p-type polysilicon, the following reaction pairs may be employed in place of reaction (4) shown above:

(5) $2\ BCl_3 + 3H_2 \dashrightarrow 2B + 6HCl$; or

(6) $2\ BBr_3 + 3H_2 \dashrightarrow 2B + 6HBR$

In each of the reactions (5), (6), the element boron (B) provides a p-type dopant in the deposited polysilicon. As discussed above in connection with reaction (3) and (4), the rate of reaction (3) is first controlled. Then, the rates of reactions (5), (6) can be controlled in accordance with the method of the invention by adding the product thereof, i.e., HCl or HBR, to the reaction chamber.

Similarly, the method of the present invention can be employed with compounds other than tantalum silicide. Indeed, the method is generally applicable to other materials having a multiplicity of stable compounds. For

example, one such exemplary material is molybdenum boride which exists in a multiplicity of stable compounds, i.e., $MoB_2$, MoB, $Mo_2B$. For such an application, the molybdenum may be provided in the form of a chloride, e.g., $MoCl_5$, or a carbonyl, e.g., $Mo(CO)_6$, while the boron may be in the form of a trichloride, e.g. $BCl_3$. In accordance with the method of the present invention, a controlled flow of HCl would control the reaction balance to secure the desired molybdenum boride.

Further, although the method of the present invention has been described with the use of HCl as the control gas, other materials (e.g.,) HBR, HF, may be substituted therefor depending upon the reactions involved. However, in accordance with the present invention, the control gas selected for a given application must be capable of favoring one or more predetermined ones of the different possible reactions during the chemical vapor deposition. More particularly, the control gas selected should be one which is produced as a product of at least some of the different possible reactions. Then, in accordance with the method of the present invention, adding such a control gas favors one or more of the reactions in which the least amount of the control gas is produced as a product.

The method of the present invention can be further illustrated by the following Examples: it being understood that the invention is not limited to the details recited therein:

Example 1

A tantalum silicide deposition was performed in accordance with the teachings of U.S. Patent No. 4,359,490, previously incorporated by reference, wherein the deposition is in the form of the silicide, $Ta_5Si_3$, which is then reacted with an underlying polysilicon layer at elevated temperatures to form the desired silicide, $TaSi_2$.

The following conditions were present during the deposition:

I. An initial polysilicon layer was deposited with a reaction temperature of 600°C to 625°C across the reaction chamber. The pressure in the reaction chamber was 0.300 torr. Silane was injected at the rate of 94 scc/min. The deposition time was 30 minutes. The resultant polysilicon film was approximately 3000°A thick.

II. The silicide in the form of $Ta_5Si_3$ was then deposited at the same reaction temperature. The pressure in the reaction chamber was 0.275 torr and silane was injected at the rate of 70 scc/min. $TaCl_5$ was used as the source and maintained at a temperature of 170°C. The deposition time was 5 minutes. The resultant $Ta_5Si_3$ film is about 1000°A thick. An Auger depth profile of the structure is shown in Figure 2A.

III. The layered $Ta_5Si_3$/polysilicon structure was then reacted at 1000°C to form the $TaSi_2$ layer.

## Example 2

The initial polysilicon layer was deposited as in step I of Example 1.

By injecting HCl into the reaction chamber, the $TaSi_2$ form of the silicide was directly deposited, without the further reaction of step III. During this reaction, the temperature was 600°C to 625°C across the reaction chamber with a pressure of 0.275 torr. Silane was injected at 70 scc/min. and HCL control gas was injected at 50 scc/min. $TaCl_5$ was used as the source and maintained at a temperature of 170°C. The deposition time was 5 minutes.

The resulting films were examined by Auger analysis as shown in Figure 2B and their peak heights compared to standard $TaSi_2$ samples to establish that the deposited films were $TaSi_2$. The deposited films were also annealed at 1000°C and re-examined through Auger analysis in which no changes in their peak heights were shown.

## Example 3

Since the addition of HCl appears to control the rate of $TaCl_5$ breakdown, it would appear to be a useful technique for control of the breakdown of other chloride type sources. One use for this technique would be in controlling dopant uniformity of LPCVD doped polysilicon.

It is well-known that preparing doped polysilicon, i.e., arsenic-doped polysilicon by simply introducing a dopant gas into the reactant injection does not uniformly dope the

deposited film because of a very rapid breakdown of the source dopant. This depletes the reactant source resulting in extremely heavy doping at the injection site and virtually none down the tube.

By introducing a reaction product into the reactant injection, it would be possible to adjust the source dopant breakdown rate to that of the polysilicon resulting in dopant uniformity throughout the reactor geometry.

Proposed Conditions:

Arsenic-doped Polysilicon

Furnace Temperature: 600-625$^{\circ}$C

Reactor Vacuum: 0.300 Torr

Silane Inject: 90 scc/min

$AsCl_3$ Source Temperature: 30$^{\circ}$C

Hydrogen Inject: 20 scc/min

HCl Inject: 20 scc/min

Since one of the reaction products of the $AsCl_3$ breakdown under these conditions will be HCl, the addition of HCl to the reaction would tend to slow the breakdown of the source resulting in uniform doping of the deposited polysilicon film from the SiH4 (silane) source.

While the present invention has been described with reference to specific embodiments thereof, it will be obvious to those skilled in the art that various changes and modifications may be made without departing from the invention in its broader aspects. It is contemplated in the appended claims to cover all such variations and

modifications of the invention which come within the true spirit and scope of my invention.

I claim:

1. A method of controlling chemical vapor deposition of multiple element materials, characterized by the steps of:
   a) providing a vapor deposition chamber,
   b) providing source materials in the chamber having different source vapor decomposition rates wherein a plurality of different reactions are possible during deposition, and
   c) adding a control gas to the chamber during deposition to favor one or more predetermined ones of the different reactions.

2. The method of claim 1 characterized in that the control gas of step c) is produced as a product of at least some of the plurality of the different possible reactions.

3. The method of claim 2 characterized in that the step c) of adding the control gas favors one or more of the predetermined reactions in which the least amount of the control gas is produced as a product thereby.

4. The method of claim 1, 2 or 3 characterized in that the different source materials comprise silane, tantalum chloride and hydrogen and in which the control gas comprises hydrochloric acid.

5. The method of claim 4 characterized in that the favored predetermined reaction produces saturated tantalum silicide.

6. The method of claim 5 characterized in that the reaction

takes place at a temperature of from about 600°C to about 650°C.

7. The method of claim 1, 2 or 3 characterized in that the different source materials comprise silane, arsenic chloride and hydrogen and in which the control gas comprises hydrochloric acid and hydrogen wherein the favored predetermined reaction provides n-type polysilicon having a predetermined dopant profile.

8. The method of any one of claims 3 - 7 characterized in that the reaction takes place at a substantially fixed temperature.

9. The method of claim 8 characterized in that the substantially fixed temperature comprises about 600°C to about 650°C.

0178200

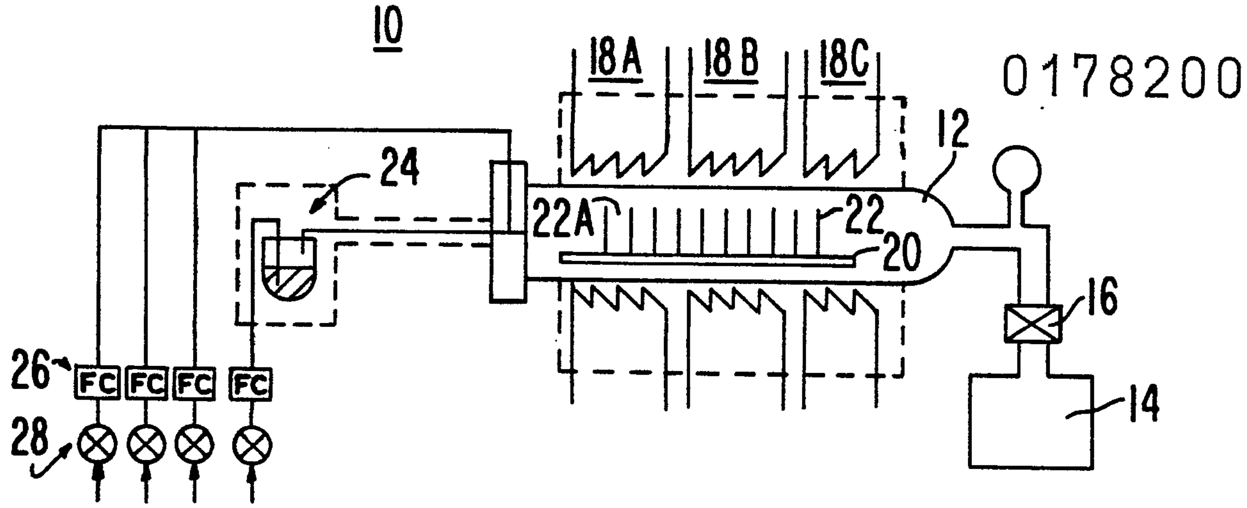


FIG. 1

FIG. 2A

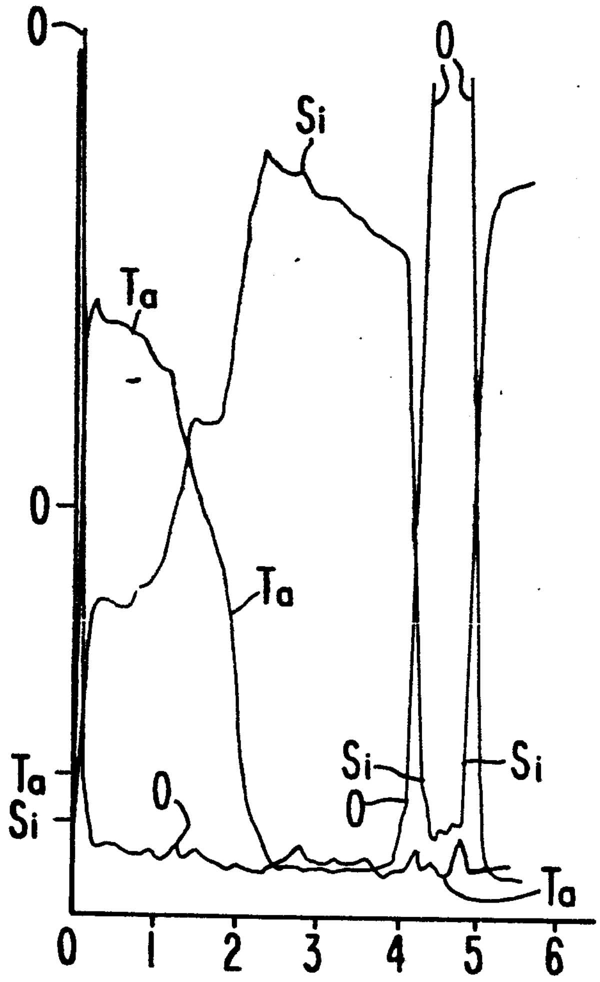


FIG. 2B

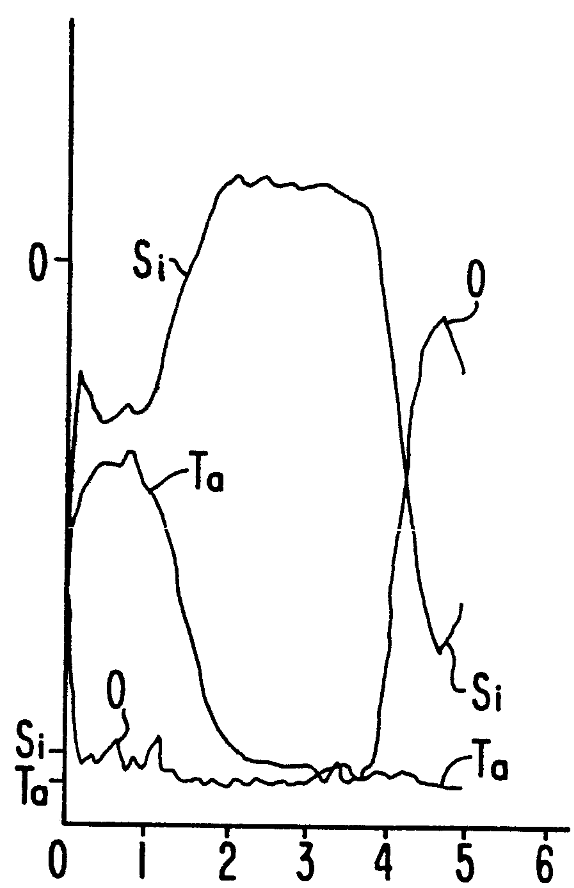

European Patent Office

# EUROPEAN SEARCH REPORT

0178200

Application number

EP 85 40 1718

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| | | | H 01 L 21/285 |
| A | EXTENDED ABSTRACTS, vol. 83, no. 2, October 1983, pages 440-441, Washington, US; W.I. LEHRER et al.: "Layered TaSi2/Poly-Si films produced by low pressure chemical vapor deposition" * page 440, paragraphs 1-3 * --- | 1,4-6 | C 23 C 16/30 |
| A | EP-A-0 090 319 (SIEMENS) * page 4, lines 9-22 * --- | 1,4 | |
| A | JOURNAL OF THE ELECTROCHEMICAL SOCIETY, vol. 127, no. 5, 7th May 1980, pages 1188-1192, Princeton, US; J. MUROTA et al.: "Arsenic doping of chemical vapor deposited polycrystalline silicon using SiH4-H2-AsH3 gas system" * page 1188, paragraph 3 * ----- | 7 | |
| | | | TECHNICAL FIELDS SEARCHED (Int. Cl.4) |
| | | | C 23 C 16/24 |
| | | | C 23 C 16/30 |
| | | | C 23 C 16/52 |
| | | | H 01 L 21/285 |

The present search report has been drawn up for all claims

| Place of search | Date of completion of the search | Examiner |
|---|---|---|
| BERLIN | 01-12-1985 | GIBBS C.S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document